(19) **Europäisches Patentamt**

**European Patent Office**

**Office européen des brevets**

(11) Veröffentlichungsnummer: **0 356 555 B1**

(12) **EUROPÄISCHE PATENTSCHRIFT**

(45) Veröffentlichungstag der Patentschrift: **27.10.93**

(51) Int. Cl.⁵: **H04N 5/60**

(21) Anmeldenummer: **88114224.4**

(22) Anmeldetag: **31.08.88**

(54) **Verfahren und Schaltungsanordnung zur Feststellung des Vorhandenseins oder Nichtvorhandenseins mindestens einer Frequenz bekannten Wertes in einem aus mehreren Frequenzen zusammengesetzten Eingangssignal.**

(43) Veröffentlichungstag der Anmeldung:
**07.03.90 Patentblatt 90/10**

(45) Bekanntmachung des Hinweises auf die Patenterteilung:
**27.10.93 Patentblatt 93/43**

(84) Benannte Vertragsstaaten:
**AT BE CH DE ES FR GB IT LI LU NL SE**

(56) Entgegenhaltungen:
**EP-A- 0 146 749**

(73) Patentinhaber: **SIEMENS AKTIENGESELL-SCHAFT**
**Wittelsbacherplatz 2**
**D-80312 München(DE)**

(72) Erfinder: **Stepp, Richard, Dipl.-Ing.**
**Elisabethstrasse 25**
**D-8000 München 40(DE)**

EP 0 356 555 B1

**Beschreibung**

Die vorliegende Erfindung betrifft ein Verfahren zur Feststellung des Vorhandenseins oder Nichtvorhandenseins mindestens einer Frequenz bekannten Wertes in einem aus mehreren Frequenzen zusammengesetzten Eingangssignal nach dem Oberbegriff des Patentanspruches 1.

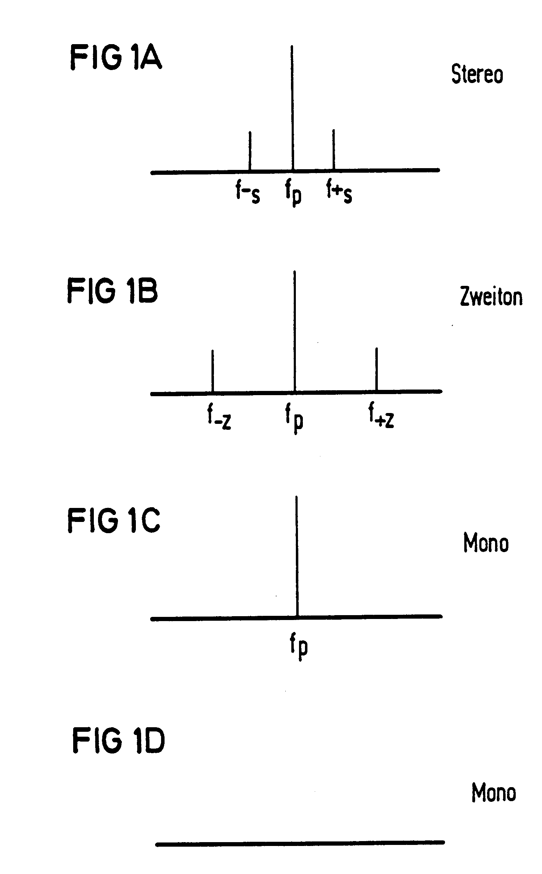

Ein Beispiel für die Notwendigkeit einer Feststellung des Vorhandenseins oder Nichtvorhandenseins bestimmter Frequenzen mit bekanntem Wert in einem aus mehreren Frequenzen zusammengesetzten Eingangssignal ist die Decodierung der Programmarterkennung im Zweiträger-Fernsehtonsystem. Einzelheiten dieses Zweiträger-Fernsehtonsystems sind in dem "CCIR-Dokument", Report 795-1 (1978 - 1982), Seiten 205 bis 213 beschrieben. Danach erfolgt die Programmarterkennung beim Zweiträger-Fernsehtonsystem mit Hilfe eines amplitudenmodulierten Pilotträgertones. Die Frequenz des Pilotträgertones ist gleich dem 3,5-fachen der Videozeilenfrequenz $f_h$. Für die Betriebsarten Stereo und Zweiton ist dem Pilotträgerton jeweils ein Kennton aufmoduliert. Die möglichen Betriebsarten sind in den FIG 1A bis 1D jeweils in Form eines Frequenzspektrums dargestellt.

FIG 1A zeigt den Fall für die Betriebsart Stereo, bei der einem Pilottonträger, dessen Frequenz mit $f_p$ bezeichnet und die gleich 3,5 . 15 625 Hz ist, durch Amplitudenmodulation ein Kennton mit einer Frequenz von 15 625/133 Hz aufmoduliert ist. Der Wert von 15 625 Hz ist dabei die Videozeilenfrequenz $f_h$. In FIG 1A sind die Seitenbänder mit $f_{+s}$ bzw. $f_{-s}$ bezeichnet.

Entsprechend zeigt die FIG 1B den Fall für die Betriebsart Zweiton, bei der dem Pilotträgerton der Frequenz $f_p$ ein Kennton mit der Frequenz 15 625/57 Hz aufmoduliert ist. Die Seitenbänder sind in diesem Fall mit $f_{+z}$ bzw. $f_{-z}$ bezeichnet.

FIG 1C zeigt die Betriebsart Mono im Zweiträger-Fernsehtonsystem, bei der lediglich der Pilotträgerton mit der Frequenz $f_p$ vorhanden ist, dem jedoch kein Kennton aufmoduliert ist.

Schließlich zeigt die FIG 1D die übliche Mono-Betriebsart bei der bisher üblichen Fernsehübertragung, bei welcher auch der Pilotträgerton nicht vorhanden ist.

Der Modulationsgrad bei den Betriebsart-Fällen nach den FIG 1A und 1B beträgt 50 %.

Die Übertragung der vorstehend erläuterten Amplitudenmodulations-Frequenzen erfolgt nun von einem Fernsehsender derart, daß der amplitudenmodulierte Pilotträgerton mittels Frequenzmodulation einem Träger im MHz-Bereich aufmoduliert wird. Im Fernsehempfänger wird zunächst eine Frequenz-Demodulation und danach eine Amplituden-Demodulation zur Gewinnung der Kenntöne durchgeführt. Die Auswertung der Information über die Betriebsarten Mono, Zweiton und Stereo kann über das obere oder untere Seitenband erfolgen. Die Auswertung der Seitenbänder ist dabei gleichwertig.

Bisher wurde die Decodierung der Programmarterkennung beim Zweiträger-Fernsehtonsystem meistens durch Synchron- oder Hüllkurvengleichrichtung des modulierten Pilotträgertones mit anschließender Auswertung der demodulierten Kenntöne durchgeführt.

Bei der Übertragung von Fernsehinformation können aufgrund von Kreuzmodulationseffekten Störfrequenzen aus dem Videoanteil der Fernsehinformation entstehen, die mit der Frequenz des Pilotträgertones gleich sind. Diese Störfrequenzen können so stark sein, daß entsprechend starke Schwankungen der Pilotträgerton-Amplitude und damit unerwünschte Störfrequenzen nach der Amplituden-Demodulation auftreten.

Aus "Funkschau", Jan.1982, No. 2, S.76 bis 79 ist bekannt, für ein Zweiträger-Fernsehtonsystem einen automatisch umschaltbaren Stereo-Zweiton-Decoder vorzusehen, bei dem die für die Kennung notwendige Umschaltinformation mittels zweier gleichartiger PLL-Schaltungen gewonnen wird, die durch Potentiometer auf die jeweilige Kennfrequenz abgestimmt sind.

Aus der EP-A 0 146 749 ist eine nach einem anderen Prinzip arbeitende Schaltungsanordnung bekannt.

Es zeigt:

FIG 2   ein Blockschaltbild einer Schaltungsanordnung nach dem Stand der Technik, der der EP-A 0 146 749 entnehmbar ist,

FIG 3   ein Blockschaltbild einer Ausführungsform eines in der Schaltungsanordnung nach FIG 2 vorgesehenen Frequenzgenerators; und

FIG 4A und 4B   jeweils ein Diagramm zur Erläuterung der Auswertung von einer zu erkennenden Frequenz entsprechenden Gleichspannungsanteilen.

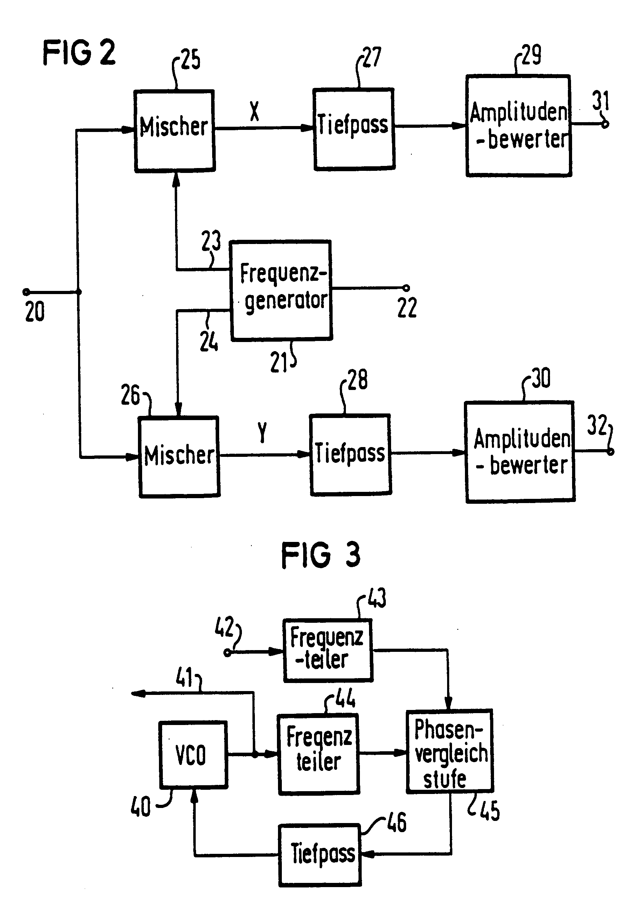

Bei der Schaltungsanordnung nach FIG 2 wird ein Eingangssignal, in dem das Vorhandensein oder Nichtvorhandensein einer Frequenz bekannten Wertes festgestellt werden soll, in einen Eingang 20 eingespeist. Dieses Eingangssignal sei der Einfachheit halber mit

A sin (omega t + fi)

bezeichnet, worin

A die Amplitude

2

Omega die Frequenz

t die Zeit, und

fi die Phase

bedeuten.

Mittels eines Frequenzgenerators 21 werden aus einer stabilen Referenzfrequenz, welche in einen Eingang 22 eingespeist wird, zwei Schaltsignale mit einer der festzustellenden Frequenz gleichen Frequenz und einem Phasenunterschied von 90° erzeugt. Die stabile Referenzfrequenz ist für den Fall des Zweiträger-Fernsehtonsystems zweckmäßigerweise die im Videosignal zur Verfügung stehende Videozeilenfrequenz $f_h$.

Das Eingangssignal am Eingang 20 wird in jeweils einen Eingang von zwei linearen Mischern 25 und 26 eingespeist. In jeweils einen weiteren Eingang der beiden Mischer 25 und 26 wird über eine Leitung 23 und 24 jeweils eines der beiden vom Frequenzgenerator 21 erzeugten Schaltsignale mit der der festzustellenden Frequenz gleichen Frequenz und einem Phasenunterschied von 90° eingespeist. In den Mischern erfolgt eine multiplikative Mischung des Eingangssignals mit dem jeweiligen Schaltsignal.

Sind die Frequenzen des Eingangssignals und der beiden Schaltsignale gleich, so liefern die Mischer an ihren Ausgängen nur noch jeweils einen Gleichspannungsanteil X bzw. Y, welche der Amplitude A und dem Phasenwinkel fi des Eingangssignals proportional sind. Speziell gilt:

X ~ A sin fi

Y ~ A cos fi

Ersichtlich wird das Eingangssignal in zwei Kanälen mit einem Phasenunterschied der Schaltsignale für die Mischer von 90° bewertet, da die Phase fi des Eingangssignals beliebig, d.h., auch Null oder 90° (oder jeweils ein Vielfaches davon mit dem Faktor 180°) sein kann, so daß der Gleichspannungsanteil gemäß den beiden vorstehend genannten Formeln bei einer Bewertung in einem Kanal verschwinden könnte.

Den beiden Mischern 25 und 26 ist jeweils ein Filter in Form eines Tiefpasses 27 bzw. 28 nachgeschaltet, das zur Ausfilterung von Wechselanteilen im Ausgangssignal des jeweiligen Mischers 25 und 26 dient. Diese Tiefpässe 27 und 28 besitzen jeweils eine Eckfrequenz von einigen Hz, vorzugsweise von höchstens 2 Hz. Die Tiefpässe 27 und 28 wirken bezüglich des Signals am Eingang 20 wie ein Bandpaß mit der Mittenfrequenz gleich der Schaltfrequenz der beiden Schaltsignale auf den Leitungen 23 und 24 und einer Bandbreite gleich der doppelten Tiefpaß-Eckfrequenz. An den Ausgängen dieser Tiefpässe treten daher nur die Gleichspannungsanteile X und Y bei Gleichheit der Frequenz des Signals am Eingang 20 und der Schaltsignale auf den Leitungen 23 und 24 auf.

Die Ausgangssignale der Tiefpässe 27 und 28 werden in jeweils einen Amplitudenbewerter 29 und 30 eingespeist, mit denen die Amplitude des Gleichspannungsanteils X bzw. Y bewertet wird. Eine Auswertung der Amplitude zur Feststellung des Vorhandenseins oder Nichtvorhandenseins einer Frequenz bekannten Wertes im Eingangssignal am Eingang 20 reicht aus, da die Phase fi des Eingangssignals willkürlich ist.

Diese Amplitudenbewertung kann auf verschiedene Weise erfolgen:

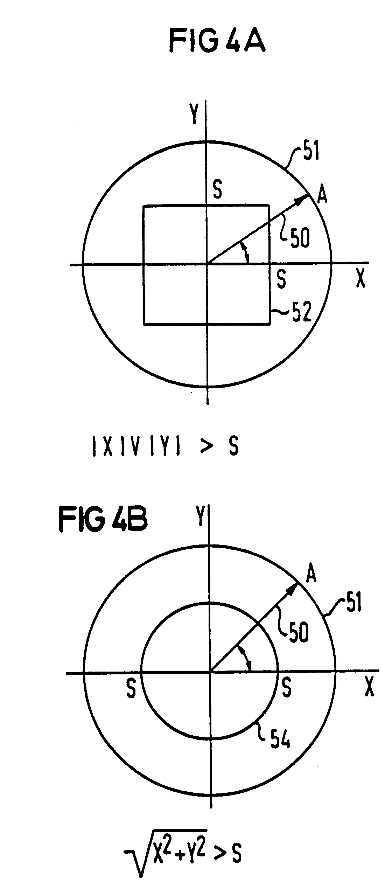

Beispielsweise können die Amplitudenbewerter 29 und 30 als an sich bekannte Schwellwertschalter ausgebildet sein, welche feststellen, ob die Absolutwerte der Gleichspannungsanteile X und Y größer als eine vorgegebene Schwelle S sind. Diese Art der Amplitudenbewertung ist im Diagramm nach FIG 4, Punkt 1 gezeigt. Der Gleichspannungsanteil ist dabei wiederum durch eine Amplitude A und einen resultierenden Winkel gegeben, so daß dieser Gleichspannungsanteil durch einen Zeiger 50 gebildet ist, der abhängig von dem beliebigen Winkel auf einem Kreis 51 liegen kann. Die als Schwellwertschalter ausgebildeten Amplitudenbewerter 29 und 30 nach FIG 2 sprechen jeweils auf einen Schwellwert S an, so daß sich für die Bewertung des Gleichspannungsanteils mit der Amplitude A und dem resultierenden Winkel ein Quadrat 52 mit der Kantenlänge S entsprechend den Schwellwerten der Schwellwertschalter ergibt. Liegt der Zeiger für den Gleichspannungsanteil entsprechend der Amplitude A außerhalb des durch den Schwellwert S definierten Quadrates 52, so wird der Gleichspannungsanteil als Maß für das Vorhandensein der festzustellenden Frequenz im Eingangssignal am Eingang 20 nach FIG 2 als gültig an Ausgängen 31 und 32 der Amplitudenbewerter 29 und 30 nach FIG 2 ausgegeben.

Eine weitere Möglichkeit der Bewertung der Gleichspannungsanteile X und Y besteht darin, die Quadratwurzel aus der Summe der Quadrate mittels konventioneller elektronischer Elemente zu ermitteln und festzustellen, ob der Wert dieser Wurzel größer als ein vorgegebener Schwellwert S ist. Dieser Sachverhalt ist im Diagramm nach FIG 4 B dargestellt, das mit der Ausnahme dem Diagramm nach FIG 4A entspricht, daß sich aufgrund der Quadratwurzel aus der Summe der Quadrate der Werte X und Y anstelle des Bewerterquadrates 52 nach FIG 4A ein Bewerterkreis 54 ergibt.

FIG 3 zeigt eine Ausführungsform zur Erzeugung der Schaltsignale für die Mischer 25 und 26 im Frequenzgenerator 21 nach FIG 2 in Form einer PLL-Schaltung. Ein spannungsgesteuerter Oszillator 40 (VCO) schwingt dabei auf einer Frequenz des Schaltsignals für die Mischer 25, 26, wobei dessen Ausgangssignal über eine Leitung 41 ausgegeben wird, welche einer der Leitungen 23 bzw. 24 nach FIG 2 entspricht. Die stabile Referenzfrequenz, die gemäß FIG 2 in den Eingang 22 eingespeist wird, wird in der Schaltung nach FIG 3 in den Eingang 42 eingespeist. Zur Frequenzanpassung ist dem Eingang 42 ein Frequenzteiler 43 und dem spannungsgesteuerten Oszillator 40 ein Frequenzteiler 44 nachgeschaltet. Die Ausgangssignale dieser Frequenzteiler 43 und 44 werden in einer Phasenvergleichsstufe 45 miteinander verglichen, wobei das Ausgangssignal der Phasenvergleichsstufe 45 über einen Tiefpaß 46 in den spannungsgesteuerten Oszillator 40 eingespeist wird, wodurch eine Frequenzregelung erfolgt.

Zur Erzeugung der beiden um 90° in der Phase verschobenen Schaltsignale auf den Leitungen 23 und 24 für die Mischer 25 und 26 kann die Ausgangsleitung 41 der PLL-Schaltung nach FIG 3 aufgeteilt werden und in einer der aufgeteilten Leitungen ein Phasenschieber vorgesehen werden, welcher das Ausgangssignal um 90° in der Phase verschiebt. Da eine derartige Schaltungsmaßnahme an sich konventioneller Natur ist, ist sie in FIG 3 nicht eigens dargestellt.

Für den konkreten Fall des Zweiträger-Fernsehtonsystems teilt der Frequenzteiler 43 die Horizontalablenkfrequenz $f_h$ von 15 625 Hz im Stereo-Fall durch 133, im Zweiton-Fall durch 57. Die zu detektierende Frequenz des oberen Seitenbandes $f_{+s}$ ergibt sich im Stereo-Fall somit zu

$$f_{+s} = 7/2\, f_h + f_h/133 \text{ bzw.}$$
$$f_{+s} = 933/266\, f_h$$

Der Kennton im Stereo-Fall liegt mit $f_h/133$ bei 117 Hz. Phasenunterschiede zwischen dem Ausgangssignal des Frequenzteilers 43 und dem Ausgangssignal des Frequenzteilers 44 führen zu Regelspikes am Ausgang der Phasenvergleicherstufe 45. Wenn die Eckfrequenz des als Regelfilter eingesetzten Tiefpasses 46 nicht klein genug ist, bzw. seine Dämpfung bei 117 Hz nicht in der Größenordnung 30-40 dB liegt, erhält man aufgrund dieser Regel-spikes eine Frequenzmodulation am VCO mit Seitenbändern, die einem vorhandenen Stereosignal entsprechen würden, und zwar auch dann, wenn kein Pilotton vorhanden ist. Durch eine den Erfordernissen entsprechende niedrige Eckfrequenz des Tiefpasses 46 und einer entsprechend geringen Loop-Bandbreite wird die PLL-Schaltung sehr träge. Die PLL-Schaltung ist sehr kritisch zu dimensionieren und die Leckströme in ihrem Regelkreis dürfen nur im nA-Bereich liegen.

Durch eine entsprechend langsame Frequenzaufbereitungsschaltung wird aber die gesamte Schaltungsanordnung, wie sie in der EP-A 0 146 749 beschrieben ist, sehr träge. Diese niedrige Loop-Bandbreite erlaubt eine zulässige Abweichung der Horizontalfrequenz in der Größenordnung von nur ca. 1 Hz. Beispielsweise bei Video-Magnetaufzeichnungen kann infolge von Gleichlaufschwankungen des Aufnahme- bzw. Wiedergabegerätes eine größere Horizontalfrequenzabweichung entstehen, so daß eine ungestörte Detektion der Tonarten-Kennfrequenz-Spektrallinie mit solchen bekannten Schaltungsanordnungen nicht möglich ist.

Der vorliegenden Erfindung liegt die Aufgabe zugrunde, eine Möglichkeit zur schnelleren Feststellung des Vorhandenseins oder Nichtvorhandenseins von Frequenzen bekannten Wertes, insbesondere der vorstehend erläuterten Kenntöne im Zweiträger-Fernsehtonsystem anzugeben, bei der Trägerstörungen keine Rolle spielen.

Diese Aufgabe wird bei einem Verfahren der eingangs genannten Art erfindungsgemäß durch die Merkmale des Patentanspruchs 1 gelöst.

Der Patentanspruch 8 beschreibt eine erfindungsgemäße Schaltungsanordnung zur Durchführung erfindungsgemäßer Verfahren.

Günstige Ausführungsvarianten sind Gegenstand von Unteransprüchen.

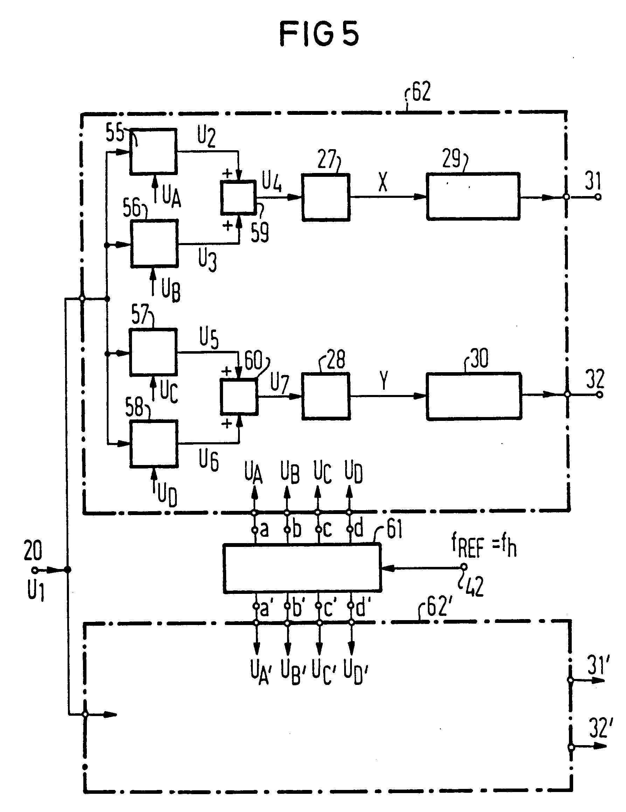

Die Erfindung wird nachstehend anhand der FIG 5, 6 und 7 näher erläutert.

Es zeigt:

FIG 5   als Blockschaltbild eine mögliche Schaltungsanordnung zur Durchführung erfindungsgemäßer Verfahren auch für den Spezialfall des gleichzeitigen Feststellens zweier verschiedener Frequenzen unter Verwendung zweier im Aufbau identischer Detektorschaltungen 62, 62'.

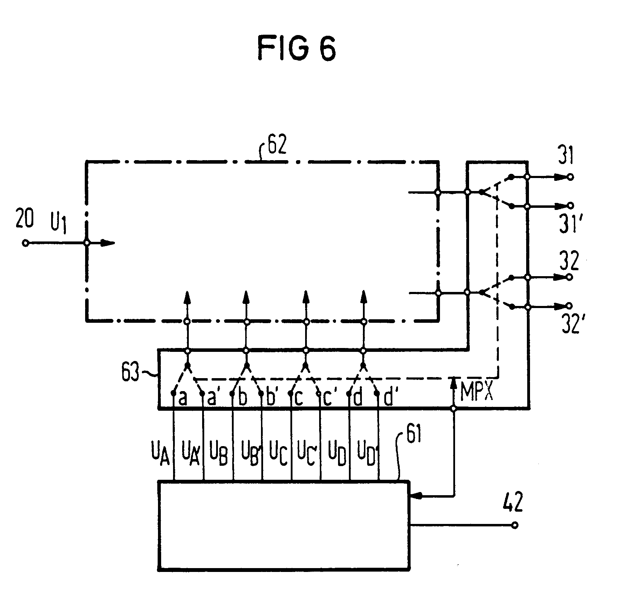

FIG 6   als Blockschaltbild eine mögliche Ausführungsform zum Feststellen zweier verschiedener Frequenzen unter Verwendung einer in FIG 5 genauer gezeigten erfindungsgemäßen Detektorschaltung 62 sowie einer Multiplex-Umschalteinrichtung 63 zum gemeinsamen Umschalten der Frequenzgeneratorausgangsklemmen a, b, c, d bzw. a', b', c', d' und der Signalausgänge 31, 32 bzw. 31', 32' der Detektorschaltung.

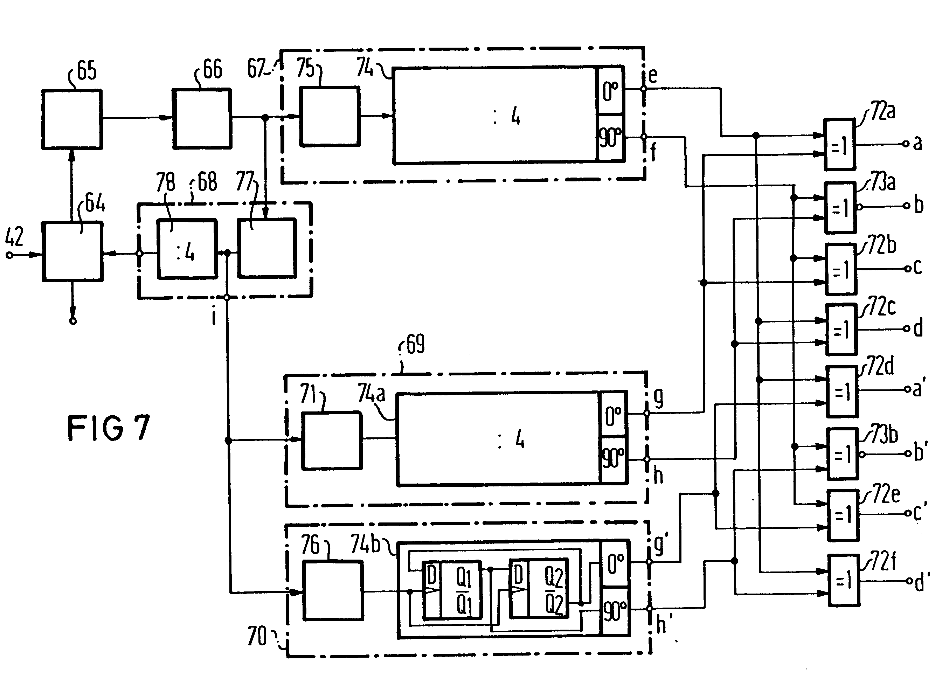

FIG 7   als Blockschaltbild eine mögliche Ausführungsform des Frequenzgenerators, auch für den Fall, daß das Vorhandensein zweier dem gleichen Trägersignal aufmodulierter Kennfrequenzen festgestellt werden kann.

FIG 5 zeigt zwei Blöcke 62 und 62', die jeweils eine identische Detektorschaltung enthalten sollen. Die Detektorschaltung 62 ist anhand von Funktions- bzw. Schaltungsblöcken genauer dargestellt. Sie enthält vier Mischer 55, 56, 57 und 58, mit linearem Übertragungsverhalten, beispielsweise 4-Quadranten-Multiplizierer, von denen jeweils ein Eingang mit der Signaleingangsklemme 20 der Gesamtschaltung verbunden ist. Diese Signaleingangsklemme 20 ist zur Beaufschlagung mit einem Eingangssignal $U_1$ vorgesehen, wobei der Zweck der Gesamtschaltung darin liegt, festzustellen, ob dieses Eingangssignal $U_1$ eine Frequenz bestimmten Wertes enthält. Beim Zweiträger-Fernsehton-System enthält dieses Signal $U_1$ beispielsweise im Bedarfsfall ein mit der Stereo-Kennsignalkreisfrequenz $omega_s$ oder mit der Zweiton-Kennsignalkreisfrequenz $omega_z$ amplitudenmoduliertes Pilottonsignal mit der Pilottonkreisfrequenz $omega_p$. Speziell für das Stereo-Kennsignal kann das Eingangssignal der Detektorschaltung folgende Form aufweisen:

$$U_1 = A(1 + m \cos (omega_s\, t + psi)) \cos(omega_p\, t + fi)$$

mit

| | |
|---|---|
| A | = Amplitude der Pilottonfrequenz |
| m | = Modulationsgrad, hier m typisch 0,5 |
| $omega_p$ | = Pilottonkreisfrequenz |
| $omega_s$ | = Stereo-Kennsignalkreisfrequenz |
| fi | = willkürliche Pilottonphase |
| psi | = willkürliche Kennsignalphase |

Der weitere Signaleingang des Mischers 55 ist mit dem Signalausgang a, der weitere Signalausgang des Mischers 56 mit dem Signalausgang b, der weitere Signalausgang des Mischers 57 mit dem Signalausgang c und der weitere Signaleingang des Mischers 58 mit dem Signalausgang d eines Frequenzgenerators 61 verbunden, der an den Signalausgängen a, b, c und d die Schaltsignale $U_A$, $U_B$, $U_C$ und $U_D$ für den Detektor 62 und, fals vorgesehen, an den weiteren Signalausgängen a', b', c' und d' die Schaltsignale $U_A'$, $U_B'$, $U_C'$ und $U_D'$ für den Detektor 62' bereitstellt. Als Referenzfrequenz für diesen Frequenzgenerator 61 dient im Fernseh-Zweikanalton-System zweckmäßigerweise die im Videosignal zur Verfügung stehende Videozeilenfrequnez $f_h$ von 15 625 Hz. Allgemein kann jedoch als Referenzfrequenz jede andere geeignete stabile Frequenz verwendet werden, die beispielsweise durch einen Quarzoszillator erzeugt wird.

In den Mischern 55, 56, 57 und 58 erfolgt eine multiplikative Mischung des Eingangssignales $U_1$ mit dem jeweiligen Schaltsignal $U_A$, $U_B$, $U_C$ bzw. $U_D$. Nur für Eingangssignalanteile, deren Frequenzen exakt gleich den im Schaltsignal enthaltenen Frequenzen sind, entstehen Gleichspannungsanteile in den Ausgangssignalen der einzelnen linearen Mischer, die den Amplituden und den Phasenwinkeln der jeweiligen Eingangssignale proportional sind. Alle anderen Eingangssignalanteile erzeugen Wechselspannungen.

Der Signalausgang des Mischers 55 und der des Mischers 56 ist jeweils an einen Signaleingang einer Addiererschaltung 59 geschaltet, der Signalausgang des Mischers 57 und der des Mischers 58 ist jeweils an einen Signalausgang einer weiteren Addiererschaltung 60 geschaltet, so daß das Ausgnagssignal $U_2$ des Mischers 55 und das Ausgangssignal $U_3$ des Mischers 56 zu einem Ausgangssignal $U_4 = U_2 + U_3$ der Addiererschaltung 59 und das Ausgangssignal $U_5$ des Mischers 57 und das Ausgangssignal $U_6$ des Mischers 58 zu einem Ausgangssignal $U_7 = U_5 + U_6$ der Addiererschaltung 60 führt. Erfindungsgemäß müssen die Schaltsignale $U_A$, $U_B$, $U_C$ und $U_D$ nach Frequenz und Phase derart gewählt sein, daß die Signale $U_4$ und $U_7$ sich nur durch einen Phasenunterschied von 90° unterscheiden.

Die besagten Addiererschaltungen 59 und 60 können beliebig aufgebaut sein, insbesondere genügt es bei üblichen 4-Quadranten-Mischern, die beiden Ausgangssignalklemmen zu verbinden und das Mischerausgangssignal durch die Differenzbildung der sich ergebenden Gesamtströme zu ermitteln. Den Signalausgängen der beiden Addiererschaltungen 59 bzw. 60 ist jeweils ein Tiefpaß 27 bzw. 28 nachgeschaltet, der analog zur oben als Stand der Technik beschriebenen Schaltung die Wechselstromanteile dieser Signale unterdrücken soll. Das Ausgangssignal X des Tiefpasses 27 wird in einem ersten Amplitudenbewerter 29 bewertet und der Ausgang dieses Amplitudenbewerters bildet die Ausgangsklemme 31 der Detektorschaltung 62, das Ausgangssignal Y des Tiefpasses 28 wird in einem zweiten Amplitudenbewerter 30 bewertet und der Ausgang dieses Amplitudenbewerters 30 bildet die Ausgangsklemme 32 der Detektorschaltung 62. Die Tiefpaßfilter 27 und 28 sowei die Amplitudenbewerter 29 und 30 können nach der Art des oben beschriebenen bekannten Verfahrens ausgeführt sein.

Durch geeignete Wahl der Phasenlage und der Frequenz der Schaltsignale $U_A$, $U_B$, $U_C$ und $U_D$ kann das obere oder das untere Seitenband des mit dem entsprechenden Kennton amplitudenmodulierten Pilottonsignales ausgewertet werden. Die Information des nichtgewünschten Seitenbandes wird durch Addition der zusammengehörenden Mischerausgänge zumindest teilweise kompensiert, die Information des gewünschten Seitenbandes wird verstärkt, bei besonders günstiger Signalform verdoppelt.

Der nachfolgenden Tabelle können die Frequenz-Phasen-Beziehungen der einzelnen Schaltsignale $U_A$, $U_B$, $U_C$ und $U_D$ zur Durchführung eines erfindungsgemäßen Verfahrens nach Anspruch 2 unter Verwendung einer erfindungsgemäßen Schaltungsanordnung nach Anspruch 8 für den Fall der Stereo-Kennfrequenz entnommen werden.

Analog werden die Frequenz-Phasen-Beziehungen der Schaltsignale $U_A'$, $U_B'$, $U_C'$ und $U_D'$ zur Detektion des Zweiton-Kennsignales angegeben. Signalformen nach der linken Spalte der Tabelle unterdrücken das untere Seitenband des mit dem Kennsignal amplitudenmodulierten Pilottones und führen zur Detektion des oberen Seitenbandes. Die rechte Spalte gibt die zur Detektion des unteren Seitenbandes führenden Frequenz-Phasen-Beziehungen der Schaltsignale an.

| Schalt-signal | Detektion des oberen Seiten-bandes | Detektion des unteren Seiten-bandes |
|---|---|---|
| $U_A$ | $\cos(\text{omega}_p\ t)\ \cos(\text{omega}_s\ t)$ | $\cos(\text{omega}_p\ t)\ \cos(\text{omega}_s\ t)$ |
| $U_B$ | $-\sin(\text{omega}_p\ t)\ \sin(\text{omega}_s\ t)$ | $\sin(\text{omega}_p\ t)\ \sin(\text{omega}_s\ t)$ |
| $U_C$ | $\sin(\text{omega}_p\ t)\ \cos(\text{omega}_s\ t)$ | $\sin(\text{omega}_p\ t)\ \cos(\text{omega}_s\ t)$ |
| $U_D$ | $\cos(\text{omega}_p\ t)\ \sin(\text{omega}_s\ t)$ | $-\cos(\text{omega}_p\ t)\ \sin(\text{omega}_s\ t)$ |
| $U_A'$ | $\cos(\text{omega}_p\ t)\ \cos(\text{omega}_z\ t)$ | $\cos(\text{omega}_p\ t)\ \cos(\text{omega}_z\ t)$ |
| $U_B'$ | $-\sin(\text{omega}_p\ t)\ \sin(\text{omega}_z\ t)$ | $\sin(\text{omega}_p\ t)\ \sin(\text{omega}_z\ t)$ |
| $U_C'$ | $\sin(\text{omega}_p\ t)\ \cos(\text{omega}_z\ t)$ | $\sin(\text{omega}_p\ t)\ \cos(\text{omega}_z\ t)$ |
| $U_D'$ | $\cos(\text{omega}_p\ t)\ \sin(\text{omega}_z\ t)$ | $-\cos(\text{omega}_p\ t)\ \sin(\text{omega}_z\ t)$ |

Die Funktionsweise der erfindungsgemäßen Schaltung wird anhand eines als Beispiel angenommenen Eingangssignals $U_1$ der Mischer 55 und 56 sowie der sich aufgrund der aus der Tabelle zur Detektion des oberen Seitenbandes entnommenen Schaltsignale $U_A$ und $U_B$ ergebenden Ausgangssignale $U_2$ und $U_3$ dieser Mischer sowie dem Ausgangssignal $U_4$ der Addiererschaltung 59 gezeigt.

Mit $x = \text{omega}_p\ t$ und $y = \text{omega}_s\ t$, wobei $\text{omega}_p$ eine Pilottonkreisfrequenz, $\text{omega}_s$ eine Stereo-Kennsignalkreisfrequenz, fi eine willkürliche Pilottonphase und psi eine willkürliche Kennsignalphase bedeuten können, gilt laut der Tabelle bei zu detektierendem oberem Seitenband für das Schaltsignal $U_A$:

$U_A = \cos(x)\ \cos(y) = 1/2\ (\cos(x{-}y) + \cos(x + y))$

und für das Schaltsignal $U_B$:

$U_B = -\sin(x)\ \sin(y) = -1/2\ (\cos(x{-}y) - \cos(x + y))$.

Ein Eingangssignal $U_1$ sei

$U_1 = A\ (1 + m\ \cos(y + psi)\ \cos(x + fi))$

oder

$U_1 = A\ (\cos(x + fi) + m/2\ (\cos(x{-}y + fi{-}psi) + \cos(x + y + fi + psi)\ ))$

Das Ausgangssignal $U_4$ der Addiererschaltung 59 setzt sich folgendermaßen zusammen:

$$U_4 = U_A U_1 + U_B U_1$$

Für das erste Produkt dieser Gleichung gilt nach den vorgenannten Bedingungen:

$U_A U_1$ = A/4 (cos(y + fi) + cos(2x-y + fi) + cos(y-fi) + cos(2x + y + fi)
+ m/2 ( cos(2y-fi-psi) + cos(2x + fi + psi)
+ cos((x + y)-(x + y)-(fi + psi)) + cos(2x + 2y + fi + psi)
+ $\overline{\text{cos((x-y)-(x-y) + (psi-fi))}}$ + cos(2x-2y + fi + psi)
+ $\overline{\text{cos(2y + psi-fi)}}$ + cos(2x + fi-psi) ))

Die beiden unterstrichenen Terme entsprechen jeweils einem Gleichspannungsanteil des Signals für den Signalanteil in $U_1$, dessen Frequenz der Summe aus der Pilottonfrequenz und der Kennfrequenz entspricht und dem Gleichspannungsanteil des Signals für den Signalanteil in $U_1$, dessen Frequenz der Differenz aus der Pilottonfrequenz und der Kennfrequenz entspricht. Die Höhe jedes Gleichspannungsanteils hängt in diesem Fall von den Phasen fi und psi ab.

Das Produkt aus $U_B$ und $U_1$ sieht folgendermaßen aus:

$U_B U_1$ = - A/4 (cos(y + fi) + cos(2x-y + fi) - cos(2x + y + fi) - cos(y-fi)
+ m/2 ( cos(2y + fi + psi) + cos(2x + fi + psi)
- $\overline{\text{cos((x + y)-(x + y) + (fi + psi))}}$ + cos(2x + 2y + fi + psi)
+ $\overline{\text{cos((x-y)-(x-y) + fi-psi))}}$ + cos(2x-2y + fi-psi)
- cos(2y-fi + psi) - cos(2x + fi-psi) ))

Auch in dieser Gleichung entsprechen die unterstrichenen Terme je einem Gleichspannungsanteil des Signals für den Signalanteil in $U_1$ mit der Frequenz aus der Summe der Pilottonfrequenz und der Kennfrequenz sowie dem Signalanteil mit der Freqzuenz, die aus der Differenz zwischen der Pilottonfrequenz und der Kennfrequenz gebildet ist.

Für das Ausgangssignal $U_4$ der Addiererschaltung 59 kann man erkennen, daß bei diesem Anwendungsfall die Gleichspannungsanteile, die aus dem der Summenfrequenz entsprechenden Signalanteil gebildet sind, addiert werden, die Gleichspannungsanteile, die aus dem der Differenzfrequenz entsprechenden Signalanteil gebildet sind, voneinander subtrahiert werden. Wählt man aus der Tabelle die Schlatsignale für das obere Seitenband, so werden die Gleichspannungsanteile der Summenfrequenzsignale voneinander subtrahiert und die Gleichspannungsanteile der Differenzfrequenzsignale addiert.

Die am Ausgang der Addiererschaltung 59 anstehenden Schwingungsterme werden mit Hilfe des nachgeschalteten Tiefpaßfilters 27 gedämpft, so daß am Ausgang dieses Tiefpaßfilters weitgehend ausschließlich ein Gleichspannungssignal X ansteht, dessen Vorhandensein vom Vorhandensein der zu detektierenden Frequenz im Eingangssignal $U_1$ abhängt und das proportional zur Amplitude A und zum Modulationsgrad m ist und außerdem von den beiden Phasenwinkeln fi und psi abhängt.

Um ein sicheres Detektieren der festzustellenden Frequenz zu ermöglichen, wird auf analoge Weise über die Mischer 57 und 58 mit geeigneten Schaltsignalen $U_C$ und $U_D$ und nachfolgend über die Addiererschaltung 60 und den Tiefpaß 28 ein zum Signal X analoges Signal Y bereitgestellt, dessen Größe von einer zusätzlich zu den Phasen fi und psi um 90° verschobenen Phase abhängt. Wenn also das Signal X am Eingang des Amplitudenbewerters 29 zur Amplitude A, zum Modulationsgrad m und dem Cosinus einer resultierenden Phase proportional ist, so ist das Signal Y am Eingang des Amplitudenbewerters 30 zur Amplitude A, zum Modulationsgrad m und dem Sinus der besagten resultierenden Phase proportional. Da die Phasenwinkel fi und psi beliebige Werte annehmen könne, werden beide Signale X und Y gleichzeitig ausgewertet. Die Ortskurve dieser Signale in einem rechtwinkligen Koordinatensystem ist ein Kreis um den Ursprung, dessen Radius proportional zu A und m ist. Die Detektorschaltung 62 oder 62' wirkt bezüglich des Eingangssignals $U_1$ wie ein Bandpaß, dessen Mittelfrequenz durch die gewählten Frequenzkomponenten, entweder das obere oder das untere Seitenband des Schaltsignales, bestimmt wird und dessen Bandbreite gleich der doppelten Tiefpaßeckfrequenz der Tiefpaßschaltung 27 bzw. 28 ist, wobei die Signale X bzw. Y proportional zu einem gleichgerichteten Ausgangssignal eines solchen Tiefpasses sind.

Die Auswertung der Signale X und Y kann in bekannter Weise durch Amplitudenbewerter vorgenommen werden, wie sie oben beschrieben sind.

FIG 7 zeigt eine Ausführungsform des Frequenzgenerators nach dem PLL-Frequenzsyntheseprinzip für den Fall, daß eine Pilotträgerfrequenz $f_p$ ein rationales Vielfaches TV 68/TV 67 einer an der Klemme 42 eingespeisten Referenzfrequenz $f_h$ ist und die Referenzfrequenz $f_h$ ein ganzzahliges Vielfaches der Modulationsfrequenzen $f_s$ und $f_z$ ist. TV 67 und TV 68 sind in diesem Fall rationale Zahlen, insbesondere Teilungsverhältnisse von Frequenzteilern.

Im einzelnen besteht der in FIG 7 gezeigte Frequenzgenerator aus einer Phasenregelschleife, die aus einem Phasendetektor 64, einem diesem nachgeschalteten Regelfiter 65, insbesondere einem Integrationsfilter und einem diesem Regelfilter 65 nachgeschalteten VCO 66, dessen Ausgangssignal über einen Frequenzteiler 68 an einen Signaleingang des besagten Phasendetektors 64 geführt ist. Der andere Eingang dieses Phasendetektors 64 wird über die Klemme 42 mit einem Referenzsignal, beispielsweise der Horizontalablenkfrequenz $f_h$ eines Fersehempfängers, beaufschlagt.

Wenn das Verhältnis der Referenzfrequenz $f_h$ zu einer Demodulationsfrequenz $f_s$ bzw. $f_z$ nicht ohne Rest durch 4 teilbar ist, ist es sinnvoll, den Frequenzteiler 68 als Reihenschaltung zweier Frequenzteiler 77 und 78 auszuführen. Die einzelnen aufzubereitenden Frequenzen werden jeweils zweimal mit einer Phasenverschiebung von 90° benötigt. Eine solche Phasenverschiebung läßt sich relativ einfach mit Hilfe von Frequenzteilern mit einem Teilungsverhältnis von 1:4 und entsprechenden Ausgängen realisieren.

Der Frequenzteiler 74b in FIG 7 zeigt einen solchen einfachen Frequenzteiler mit zwei Ausgängen, die das gleiche Signal phasenverschoben bereitstellen.

Am Ausgang des VCO kann die PLL-Frequenz, die um den Faktor des Teilungsverhältnisses TV 68 des Teilers 68 größer als die an der Klemme 42 eingespeiste Referenzfrequenz ist, geführt werden. Über einen Frequenzteiler 67 mit breitbandigem Phasenschieber wird die Ausgangsfrequenz des VCO 66 mit einem Teilungsverhältnis TV 67 geteilt und an den Ausgängen e und f dieses Frequenzteilers 67 wird ein als Trägersignal vorgesehenes Signal mit einem Phasenunterschied von 90° bereitgestellt.

Beim Fernseh-Zweikanalsystem, wenn an Klemme 42 die Horizontal-Ablenkfrequenz $f_h$ eingespeist wird und die Pilottonfrequenz $f_p$ die 3,5-fache Horizontalablenkfrequenz ausmacht, gilt für das Verhältnis des Teilungsverhältnisses TV 68 des Frequenzteilers 68 zu dem Teilungsverhältnis TV 67 des Frequenzteilers 67: TV 68/ TV 67 = 3,5.

Das VCO-Ausgangssignal kann auch als Eingangssignal für weitere Frequenzteiler oder Frequenzteiler-Serienschaltungen vorgesehen sein.

Ebenso kann das Ausgangssignal des Frequenzteilers 68 als Grundlage zum Aufbereiten der übrigen benötigten Signale dienen. In FIG 7 ist ein Verfahren gezeigt, das sich besonders bei der Verwendung von 1:4-Phasenschieber-Frequenzteilern als Ausgangsstufe als sinnvoll erweist. Der Frequenzteiler 68 besteht hier aus einem Frequenzteiler 77, dessen Teilungsverhältnis TV 77 um den Faktor 4 größer ist, als das erforderliche Teilungsverhältnis TV 68 und aus einem Frequenzteiler 78 mit einem Teilungsverhältnis TV 78 von 1:4, der dem Frequenzteiler 77 nachgeschaltet ist und dessen Ausgangssignal zur Beaufschlagung des oben beschriebenen Einganges des Phasendetektors 64 vorgesehen ist.

Der Signalausgang i des Frequenzteilers 77 ist an den Signaleingang eines Frequenzteilers 69 geschaltet. Der Frequenzteiler 69 besitzt zwei Ausgänge g und h, die das gleiche Signal mit einer Phasendrehung von 90° bereitstellen. Zur Generierung der Schaltsignale, die den Stereofall bei einem Zweiträger-Fernsehton detektieren sollen, hat in einer günstigen Ausführungsform der Frequenzteiler 77 das Teilungsverhältnis TV 77 von 1:7 und der Frequenzteiler 69 besteht aus einem 1:4-Frequenzteiler 74a, der an die Ausgänge g und h geschaltet ist sowie einen Frequenzteiler 71 mit einem Teilungsverhältnis TV 71 von 1:133, der zwischen die Frequenzteiler 77 und 74a geschaltet ist. Zur Generierung der Schaltsignale zur Detektion des Zweitonfalles beim Zweiträgerfernsehtonsystem ist analog zum Frequenzteiler 69 ein Frequenzteiler 70 mit den Ausgangsklemmen g' und h' erforderlich, wobei der Frequenzteiler 70 sich vom Frequenzteiler 69 nur in seinem Teilungsverhältnis unterscheidet. Wenn der Frequenzteiler 70 aus der Serienschaltung eines Frequenzteilers 76 und eines 1:4-Frequenzteilers 74b besteht, so weist der Frequenzteiler 76 ein Teilungsverhältnis TV 76 von 1:57 auf.

Mit Hilfe von breitbandigen Phasenschiebern 74, 74a und 74b stehen die 0°- und die 90°-Komponenten der generierten Signale zur Verfügung. Die entsprechenden Schaltsignale $U_A$, $U_B$, $U_C$, $U_D$ und erforderlichenfalls $U_A'$, $U_B'$, $U_C'$ und $U_D'$ werden durch logische Exklusiv-Oder-Verknüpfung erzeugt.

Der Signalausgang e ist mit einem Eingang eines EXOR-Gatters 72a, eines EXOR-Gatters 72c, eines EXOR-Gatters 72d und EXOR-Gatters 72f zusammengeschaltet. Der Signalausgang f ist mit einem Eingang eines EXNOR-Gatters 73a, eines EXOR-Gatters 72b, eines EXNOR-Gatters 73b und eines EXOR-Gatters 72e zusammengeschaltet. Der Signalausgang g ist jeweils an den anderen Signaleingang des EXOR-Gatters 72a und des EXOR-Gatters 72b geschaltet. Der Signalausgang f ist jeweils mit dem anderen Eingang des EXNOR-Gatters 73a und des EXOR-Gatters 72c verbunden. Der Signalausgang g' ist jeweils an den anderen Signaleingang des EXOR-Gatters 72d und des EXOR-Gatters 72e angeschlossen. Der Signalausgang h' ist jeweils mit dem anderen Signaleingang des EXNOR-Gatters 73b und des EXOR-Gatters 72f zusammengeschaltet.

Der Ausgang des EXOR-Gatters 72a bildet die Ausgangsklemme a des Frequenzgenerators 61, der Ausgang des EXNOR-Gatters 73a die Ausgangsklemme b, der des EXOR-Gatters 72b die Ausgangsklemme c, der des EXOR-Gatters 72c die Ausgangsklemme d, der des EXOR-Gatters 72d die Ausgangsklemme a', der EXNOR-Gatters 73b die Ausgangsklemme b', der des EXOR-Gatters 72e die Ausgangsklemme c', und der Ausgang des EXOR-Gatters 72f bildet die Ausgangsklemme d' des Frequenzgenerators 61.

Der Vorteil dieses Frequenzgenerators besteht darin, daß die Schaltsignale für beide Kenntöne in einer PLL-Schleife erzeugt werden und die relativ hohe Referenzfrequenz als Vergleichsfrequenz für den Phasendetektor dient. Ein weiterer Vorteil einer solchen Ausführungsform, speziell bei Fersehgeräten, ist, daß der eingerastete Zustand der PLL-Schleife 64, 65, 66, 68 zugleich als Indikator für das Vorhandensein der Videozeilenfrequenz dienen kann und somit als Koinzidenz- bzw. Mutingfunktion eingesetzt werden kann.

Sowie in FIG 6 anstelle zweier parallelgeschalteter Detektorschaltungen nur ein Detektor vorgesehen ist, dessen Eingangs- und Ausgangsklemmen im Multiplexbetrieb umgeschaltet werden können, kann auch im Frequenzgenerator anstelle der Frequenzteiler 69 und 70 nur ein Frequenzteiler vorgesehen sein, dessen Teilungsverhältnis entsprechend umschaltbar ist.

**Patentansprüche**

1. Verfahren zur Feststellung des Vorhandenseins oder Nichtvorhandenseins mindestens einer Frequenz bekannten Wertes in einem aus mehreren Frequenzen zusammengesetzten Eingangssignal ($U_1$), bei dem dieses Eingangssignal ($U_1$) in je einen Signaleingang mehrerer Mischer eingespeist wird, bei dem die Eingangssignale für die übrigen Signaleingänge dieser Mischer von einer stabilen Referenzfrequenz hergeleitet sind, bei dem die jeweiligen Mischprodukte zur Ausfilterung von darin enthaltenen Wechselanteilen jeweils einer Filterung unterworfen werden und bei dem nach dieser Filterung eine Amplitudenbewertung eines bei Vorhandensein der Frequenz bekannten Wertes im jeweiligen Mischprodukt enthaltenen Gleichspannungsanteils durchgeführt wird,
   **dadurch gekennzeichnet**,
   daß das Eingangssignal ($U_1$) an je einen Eingang von vier Mischern (55, 56, 57, 58) eingespeist wird, daß jeweils die Ausgangssignale ($U_2$, $U_3$ und $U_5$, $U_6$) zweier Mischer (55, 56 und 57, 58) additiv verknüpft werden, daß aus der Referenzfrequenz vier Schaltsignale ($U_A$, $U_B$, $U_C$, $U_D$) mit einer der festzustellenden Frequenz gleichen Frequenz abgeleitet werden, daß zwischen diesen vier Schaltsignalen ($U_A$, $U_B$, $U_C$, $U_D$) eine feste Phasenbeziehung derart besteht, daß jeweils durch die additive Verknüpfung der Ausgangssignale ($U_2$, $U_3$ und $U_5$, $U_6$) der beiden entsprechend zu schaltenden Mischer (55, 56 und 57, 58) die Signalanteile eines eventuell vorhandenen unerwünschten Seitenbandes unterdrückt und die Signalanteile mit der festzustellenden Frequenz durch die Überlagerung der jeweiligen beiden Mischerausgangssignale ($U_2$, $U_3$ und $U_5$, $U_6$) vergrößert werden und daß die Grundkomponenten der beiden nach der jeweiligen Summenbildung bereitgestellten Ausgangssignale ($U_4$, $U_7$) zueinander einen Phasenwinkel von 90° aufweisen.

2. Verfahren nach Anspruch 1 zur Feststellung von in einem Zweiträger-Fernsehtonsystem einem Pilottonträger aufmodulierten Kennfrequenzen,
   **dadurch gekennzeichnet,**
   daß als Referenzfrequenz die Videozeilenfrequenz verwendet wird und daß aus der Videozeilenfrequenz Schaltsignale in Form amplitudenmodulierter Signale erzeugt werden, deren Trägerfrequenz der Pilottonfrequenz und deren Frequenz des Modulationssignales der festzustellenden Kennfrequenz entspricht.

3. Verfahren nach Anspruch 1 oder 2,
   **dadurch gekennzeichnet,**
   daß die Ausfilterung von in den Mischprodukten enthaltenen Wechselanteilen mittels einer Tiefpaßfilterung durchgeführt wird.

4. Verfahren nach einem der Ansprüche 1 bis 3,
   **dadurch gekennzeichnet,**
   daß die Amplitudenbewertung dadurch erfolgt, daß die Absolutwerte des bei Vorhandensein der Frequenz bekannten Wertes im jeweiligen Mischprodukt enthaltenen Gleichspannungsanteils einer Schwellwertbestimmung unterworfen werden.

**5.** Verfahren nach einem der Ansprüche 1 bis 3,
**dadurch gekennzeichnet,**
daß die Amplitudenbewertung dadurch erfolgt, daß der Wert der Quadratwurzel der Summe der Quadrate der Absolutwerte des bei Vorhandensein der Frequenz bekannten Wertes im jeweiligen Mischprodukt enthaltenen Gleichspannungsanteils einer Schwellwertbestimmung unterworfen wird.

**6.** Verfahren nach einem der Ansprüche 1 bis 5,
**dadurch gekennzeichnet,**
daß die Feststellung mehrerer Frequenzen bekannten Wertes in parallelen Kanälen erfolgt, in denen die Schaltsignale jeweils die Frequenz einer festzustellenden Frequenz besitzen.

**7.** Verfahren nach einem der Ansprüche 1 bis 5,
**dadurch gekennzeichnet,**
daß die Feststellung mehrerer Frequenzen bekannten Wertes im Multiplexbetrieb durch Umschaltung der Schaltsignale auf die jeweilige festzustellende Frequenz erfolgt.

**8.** Schaltungsanordnung zur Durchführung des Verfahrens nach einem der Ansprüche 1 bis 7,
**gekennzeichnet** durch einen von der stabilen Referenzfrequenz angesteuerten Frequenzgenerator (61) zur Erzeugung der Schaltsignale, jeweils einen an einen Ausgang des Frequenzgenerators (61) für ein Schaltsignal angekoppelten Mischer (55, 56, 57, 58) mit jeweils einem Eingang für das Eingangssignal (U1), in dem das Vorhandensein oder Nichtvorhandensein mindestens einer Frequenz bekannten Wertes festgestellt werden soll, und jeweils einem Eingang für ein spezifisches Schaltsignal ($U_A$, $U_B$, $U_C$ und $U_D$), zwei Additionsschaltungen (59, 60) mit jeweils zwei Eingängen mit einem Ausgang, wobei der Ausgang zweier Mischer (55, 56; 57, 58) jeweils mit je einem Eingang einer Additionsschaltung (59, 60) zusammengeschaltet ist, jeweils ein an den Ausgang jeweils einer Additionsschaltung (59, 60) angekoppeltes Filter (27, 28) zur Ausfilterung von Wechselanteilen in den Mischerausgangssignalen und jeweils eine an den Ausgang jeweils eines Filters (27, 28) angekoppelte Amplitudenbewerterstufe (29, 30).

**9.** Schaltungsanordnung nach Anspruch 8,
**dadurch gekennzeichnet,**
daß der Frequenzgenerator (61) als PLL-Schaltung (64, 65, 66, 68) ausgebildet ist.

**10.** Schaltungsanordnung nach einem der Ansprüche 8 oder 9,
**dadurch gekennzeichnet,**
daß bei einer Schaltungsanordnung zur Feststellung einer Frequenz bekannten Wertes die PLL-Schaltung des Frequenzgenerators vier Signalausgänge (e, f, g, h; g' h') aufweist, wobei je zwei dieser Signalausgänge (e, f; g, h;) Signale der gleichen Frequenz mit unterschiedlicher Phasenlage führen, daß diese Signalausgänge (e, f, g, h; g', h') an die Signaleingänge von Logikgattern (72a, 73a, 72b, 72c; 72d,...) geschaltet sind und die Signalausgänge dieser Logikgatter (72a u.s.w.) die Ausgangsklemmen (a, b, c, d; a', ...) des Frequenzgenerators (61) bilden.

**Claims**

**1.** Method for determining the presence or absence of at least one frequency of known value in an input signal ($U_1$) composed of a plurality of frequencies, in which this input signal ($U_1$) is fed into one signal input each of a plurality of mixers, in which the input signals for the remaining signal inputs of these mixers are derived from a stable reference frequency, in which the respective mixer products are in each case subjected to filtering in order to filter out alternating components contained therein, and in which, after this filtering, amplitude evaluation of a DC voltage component contained in the respective mixer product given the presence of the frequency of known value is carried out, characterised in that the input signal ($U_1$) is fed in at one input each of four mixers (55, 56, 57, 58), in that in each case the output signals ($U_2$, $U_3$ and $U_5$, $U_6$) of two mixers (55, 56 and 57, 58) are additively combined, in that four switch signals ($U_A$, $U_B$, $U_C$, $U_D$) having a frequency equal to the frequency to be determined are derived from the reference frequency, in that a fixed phase relationship exists between these four switch signals ($U_A$, $U_B$, $U_C$, $U_D$) such that, due in each case to the additive combination of the output signals ($U_2$, $U_3$ and $U_5$, $U_6$) of the two mixers (55, 56 and 57, 58) correspondingly to be switched, the signal components of a possibly present undesired sideband are suppressed and the signal components having the frequency to be determined are amplified by the superimposition of the respective two mixer output signals ($U_2$, $U_3$ and $U_5$, $U_6$), and that the fundamental components of the two output signals ($U_4$, $U_7$) provided after the respective summation have a mutual phase angle of 90°.

2. Method according to Claim 1 for determining characteristic frequencies modulated onto a pilot tone carrier in a two-carrier television sound system, characterised in that the video line frequency is used as the reference frequency, and in that switch signals are generated from the video line frequency in the form of amplitude-modulated signals whose carrier frequency corresponds to the pilot tone frequency and whose frequency of the modulation signal corresponds to the characteristic frequency to be determined.

3. Method according to Claim 1 or 2, characterised in that filtering out alternating components contained in the mixer products is carried out by means of low-pass filtering.

4. Method according to one of Claims 1 to 3, characterised in that the amplitude evaluation is performed by subjecting to a threshold-value determination the absolute values of the DC voltage component contained in the respective mixer product given the presence of the frequency of known value.

5. Method according to one of Claims 1 to 3, characterised in that the amplitude evaluation is performed by subjecting to a threshold-value determination the value of the square root of the sum of the squares of the absolute values of the DC voltage component contained in the respective mixer product given the presence of the frequency of known value.

6. Method according to one of Claims 1 to 5, characterised in that the determination of a plurality of frequencies of known value is performed in parallel channels in which the switch signals respectively have the frequency of a frequency to be determined.

7. Method according to one of Claims 1 to 5, characterised in that the determination of a plurality of frequencies of known value is performed in multiplex mode by switching the switch signals over to the respective frequency to be determined.

8. Circuit arrangement for carrying out the method according to one of Claims 1 to 7, characterised by a frequency generator (61) for generating the switch signals which is driven by the stable reference frequency, in each case one mixer (55, 56, 57, 58) which is coupled to an output of the frequency generator (61) for a switch signal and in each case has an input for the input signal ($U_1$) in which the presence or absence of at least one frequency of known value is to be determined, and in each case one input for a specific switch signal ($U_A$, $U_B$, $U_C$ and $U_D$), two addition circuits (59, 60) with in each case two inputs and having one output, the output of two mixers (55, 56; 57, 58) being interconnected in each case to one input each of an addition circuit (59, 60), in each case a filter (27, 28), coupled to the output of in each case one addition circuit (59, 60), for filtering out alternating components in the mixer output signals, and in each case an amplitude evaluation stage (29, 30) coupled to the output of in each case one filter (27, 28).

9. Circuit arrangement according to Claim 8, characterised in that the frequency generator (61) is constructed as a PLL circuit (64, 65, 66, 68).

10. Circuit arrangement according to one of Claims 8 or 9, characterised in that in the case of a circuit arrangement for determining a frequency of known value the PLL circuit of the frequency generator has four signal outputs (e, f, g, h; g', h'), two of these signal outputs (e, f; g, h) in each case conducting signals of the same frequency and having a different phase angle, and in that these signal outputs (e, f, g, h; g', h') are connected to the signal inputs of logic gates (72a, 73a, 72b, 72c; 72d, ...) and the signal outputs of these logic gates (72a etc.) form the output terminals (a, b, c, d; a', ...) of the frequency generator (61).

**Revendications**

1. Procédé pour déterminer l'existence ou l'absence d'au moins une fréquence de valeur connue dans un signal d'entrée ($U_1$) formé par la réunion de plusieurs fréquences, dans lequel ce signal d'entrée ($U_1$) est introduit à une entrée respective de signaux de plusieurs mélangeurs, dans lequel les signaux d'entrée pour les autres entrées de signaux de ces mélangeurs sont obtenus à partir d'une fréquence de référence stable, dans lequel les produits mixtes respectifs sont soumis respectivement à un filtrage, pour séparer les composantes alternatives contenues dans ces produits, et dans lequel, après ce filtrage, on réalise, dans le cas de la présence de la fréquence de valeur connue une évaluation de l'amplitude d'une composante de tension continue contenue dans le produit mixte, caractérisé par le fait que le signal d'entrée ($U_1$) est envoyé respectivement à une entrée de quatre mélangeurs (55,56,57,58), que respectivement les signaux de sortie ($U_2$, $U_3$ et $U_5$, $U_6$) de deux mélangeurs (55, 56 et 57, 58) sont combinés de façon additive, que quatre signaux de commutation ($U_A$, $U_B$, $U_C$, $U_D$) possédant une fréquence égale à la fréquence devant être déterminée, sont obtenus à partir de la fréquence de référence, qu'une relation de phase fixe existe entre ces quatre signaux de commutation ($U_A$, $U_B$, $U_C$, $U_D$), que les composantes de signaux d'une bande latérale indésirable, qui existent éventuellement, sont supprimées respectivement par la combinaison additive des signaux de sortie ($U_2$, $U_3$ et $U_5$, $U_6$) des deux mélangeurs (55, 56 et 57, 58), qui doivent être commutés de façon correspondante, et les composantes de signaux possédant la fréquence devant être déterminée sont accrues par superposition des deux signaux de sortie respectifs ($U_2$, $U_3$ et $U_5$, $U_6$) des mélangeurs, et que les composantes de base des deux signaux de sortie ($U_4$, $U_7$), préparés après formation respective de la somme, font entre eux un angle de phase de 90°.

2. Procédé suivant la revendication 1 pour déterminer des fréquences caractéristiques modulant une porteuse du son pilote dans un système acoustique de télévision à deux porteuses, caractérisé par le fait qu'on utilise la fréquence de lignes vidéo en tant que fréquence de référence et qu'à partir de la fréquence de lignes vidéo, des signaux de commutation sont produits sous la forme de signaux modulés en amplitude, dont la fréquence porteuse correspond à la fréquence du son pilote et dont la fréquence du signal de modulation correspond à la fréquence caractéristique devant être déterminée.

3. Procédé suivant la revendication 1 ou 2, caractérisé par le fait que la séparation par filtrage de composantes alternatives contenues dans les produits mixtes est réalisée au moyen d'un filtrage passe-bas.

4. Procédé suivant l'une des revendications 1 à 3, caractérisé par le fait que l'évaluation de l'amplitude est obtenue par le fait qu'on soumet les valeurs absolues de la composante de tension continue, contenue dans le produit mixte respectif lors de la présence de la fréquence de valeur connue, à une détermination d'une valeur de seuil.

5. Procédé suivant l'une des revendications 1 à 3, caractérisé par le fait que l'évaluation de l'amplitude est obtenue par le fait qu'on soumet la valeur de la racine carrée de la somme des carrés des valeurs absolues de la composante de tension continue contenue dans le produit mixte respectif lors de la présence de la fréquence de valeur connue, à une détermination de la valeur de seuil.

6. Procédé suivant l'une des revendications 1 à 5, caractérisé par le fait que la détermination de plusieurs fréquences possédant la valeur connue s'effectue dans des canaux parallèles, dans lesquels les signaux de commutation possèdent respectivement la valeur d'une fréquence devant être déterminée.

7. Procédé suivant l'une des revendications 1 à 5, caractérisé par le fait que la détermination de plusieurs fréquences possédant une valeur connue s'effectue dans le fonctionnement multiplex, par commutation des signaux de commutation sur la fréquence respective devant être déterminée.

8. Montage pour la mise en oeuvre du procédé suivant l'une des revendications 1 à 7, caractérisé par un générateur de fréquences (61), commandé par la fréquence de référence stable et servant à produire les signaux de commutation, par respectivement un mélangeur (55,56,57,58) accouplé à une sortie du générateur de fréquence (61) pour un signal de commutation et comportant respectivement une entrée pour le signal d'entrée (U1), dans lequel l'existence ou l'absence d'au moins une fréquence de valeur connue doit être déterminée, et respectivement une entrée pour un signal de commutation spécifique ($U_A$, $U_B$, $U_C$, $U_D$), par deux circuits additionneurs (59,60) comportant respectivement deux entrées et une sortie, la sortie de deux mélangeurs (55,56; 57,58) étant interconnectée respectivement à une entrée respective d'un circuit additionneur (59,60), par respectivement un filtre (27,28) couplé à la sortie respectivement d'un circuit additionneur (59,60) et servant à éliminer par filtrage des composantes alternatives dans les signaux de sortie des mélangeurs et par respectivement un étage d'évaluation d'amplitude (29,30) couplé à la sortie d'un filtre respectif (27,28).

9. Montage suivant la revendication 8, caractérisé par le fait que le générateur de fréquences (61) est réalisé sous la forme d'un circuit PLL (64,65,66,68).

10. Montage suivant l'une des revendications 8 ou 9, caractérisé par le fait que dans le cas d'un montage pour déterminer une fréquence de valeur connue, le circuit PLL du générateur de fréquences comporte quatre sorties de signaux (e,f,g,h; g',h'), deux de ces sorties de signaux (e,f; g,h) délivrant des signaux possédant la même fréquence et des positions de phase différentes, que ces sorties de signaux (e,f,g,h; g',h') sont raccordées aux entrées de signaux de portes logiques (72a,73a;72b,72c;72d,...) et que les sorties de signaux de ces portes logiques (72a, etc.) constituent les bornes de sortie (a,b,c,d;a',...) du générateur de fréquences (61).

# FIG 1A

Stereo

$$f{-}_s \quad f_p \quad f{+}_s$$

# FIG 1B

Zweiton

$$f_{-z} \quad f_p \quad f_{+z}$$

# FIG 1C

Mono

$$f_p$$

# FIG 1D

Mono

FIG 2

FIG 3

## FIG 4A

$$|X| \vee |Y| > S$$

## FIG 4B

$$\sqrt{X^2 + Y^2} > S$$

# FIG 5

# FIG 6

FIG 7

EP 0 356 555 B1